# EUROPÄISCHE PATENTSCHRIFT

(11) **EP 2 558 232 B1**
(45) Veröffentlichungstag und Bekanntmachung des Hinweises auf die Patenterteilung: **12.07.2017**
(21) Anmeldenummer: 11714743.9
(22) Anmeldetag: 11.04.2011
(51) Int. Cl.: B22D 27/04, C01B 33/02, C30B 15/00, C30B 29/06, C30B 35/00

(54) **HERSTELLUNG VON MONOKRISTALLINEN HALBLEITERWERKSTOFFEN**
PRODUCTION OF MONOCRYSTALLINE SEMICONDUCTOR MATERIALS
FABRICATION DE MATÉRIAUX SEMI-CONDUCTEURS MONOCRISTALLINS

(30) Priorität: 14.05.2010 DE 102010021004; 13.04.2010 DE 102010015354
(43) Veröffentlichungstag der Anmeldung: 20.02.2013
(73) Patentinhaber: Schmid Silicon Technology GmbH, 72250 Freudenstadt (DE)
(72) Erfinder: KERAT, Uwe, 72270 Baiersbronn (DE); SCHMID, Christian, 72250 Freudenstadt (DE); HAHN, Jochem, 72108 Rottenburg a. N. (DE)
(74) Vertreter: Patentanwaltskanzlei Cartagena
(86) Internationale Anmeldenummer: PCT/EP2011/055626
(87) Internationale Veröffentlichungsnummer: WO 2011/128292

(56) Entgegenhaltungen:
- US-A- 3 658 119
- US-A- 4 102 767
- US-A- 5 961 944

## Beschreibung

Die vorliegende Erfindung betrifft ein Verfahren zur Herstellung von monokristallinen Halbleiterwerkstoffen, insbesondere von monokristallinem Silizium. Weiterhin betrifft die vorliegende Erfindung eine Anlage zur Herstellung solcher monokristalliner Halbleiterwerkstoffe.

Elementares Silizium findet in unterschiedlichen Reinheitsgraden unter anderem in der Photovoltaik (Solarzellen) und in der Mikroelektronik (Halbleiter, Computerchips) Verwendung. Demgemäß ist es üblich, elementares Silizium an Hand seines Reinheitsgrades zu klassifizieren. Man unterscheidet beispielsweise "Electronic Grade Silizium" mit einem Anteil an Verunreinigungen im PPT-Bereich und "Solar Grade Silizium", das einen etwas höheren Anteil an Verunreinigungen aufweisen darf.

Bei der Herstellung von Solar Grade Silizium und Electronic Grade Silizium geht man stets von metallurgischem Silizium (in der Regel 98-99 % Reinheit) aus und reinigt dieses über ein mehrstufiges, aufwendiges Verfahren auf. So ist es beispielsweise möglich, das metallurgische Silizium in einem Wirbelschichtreaktor mit Chlorwasserstoff zu Trichlorsilan umzusetzen, das anschließend zu Siliziumtetrachlorid und Monosilan disproportioniert wird. Letzteres lässt sich thermisch in seine elementaren Bestandteile Silizium und Wasserstoff zersetzen. Ein entsprechender Verfahrensablauf ist beispielsweise in der WO 2009/121558 A2 beschrieben.

Das auf diesem Weg erhaltene Silizium weist in aller Regel mindestens eine ausreichend hohe Reinheit auf, um als Solar Grade Silizium klassifiziert zu werden. Noch höhere Reinheiten lassen sich gegebenenfalls durch nachgeschaltete zusätzliche Aufreinigungsschritte erzielen. Gleichzeitig ist es für viele Anwendungen günstig oder sogar erforderlich, das aus obigem Verfahren hervorgehende und in der Regel polykristallin anfallende Silizium in monokristallines Silizium umzuwandeln. So weisen Solarzellen aus monokristallinem Silizium einen in der Regel deutlich höheren Wirkungsgrad auf als Solarzellen aus polykristallinem Silizium.

Die Umwandlung von polykristallinem Silizium in monokristallines erfolgt in der Regel durch Aufschmelzen des polykristallinen Siliziums und anschließendes Kristallisieren in monokristalliner Struktur mit Hilfe eines Impfkristalles.

Aus der US 4102767 A ist beispielsweise ein Verfahren zur Herstellung von Silizium bekannt, bei dem eine Silizium-Vorläuferverbindung in einem Lichtbogen mit einem Reduktionsmittel umgesetzt wird. Entstehendes Silizium wird in einen sogenannten Reduktionsreaktor eingespeist. Aus diesem wird flüssiges Silizium in eine flache Gussform überführt, in der man es abkühlen lässt. In einer Heizzone kann bereits erstarrtes Silizium noch einmal aufgeschmolzen werden, beispielsweise mittels eines Lasers, zwecks Überführung in einen Einkristall.

In der US 5961944 A wird die Herstellung und Aufreinigung von hochreinem Silizium beschrieben, wobei flüssiges Silizium einer gerichteten Erstarrung unterzogen wird.

Eine Technik zur Herstellung von monokristallinem Silizium, mit der es möglich ist, Silizium-Einkristalle mit besonders hohem Reinheitsgrad herzustellen, ist das sogenannte Zonenschwebeverfahren oder Float-Zone-Verfahren (FZ), das zuerst von Keck und Golay vorgeschlagen wurde. Eine Ausführungsform eines FZ-Verfahrens bzw. einer für ein solches Verfahren geeigneten Vorrichtung sind z.B. in der EP 1595006 B1 dargestellt.

Die FZ-Technik bietet gegenüber alternativen Verfahren wie zum Beispiel dem bekannten Czochralski-Verfahren einige deutliche Vorteile, insbesondere was die Reinheit des gewonnenen monokristallinen Siliziums angeht. Bei FZ-Verfahren wird die zur Kristallzüchtung verwendete Siliziumschmelze nämlich nicht in einem Tiegel gehalten. Stattdessen wird das untere Ende eines Stabes aus Polysilizium in den Heizbereich einer Induktionsheizung abgesenkt und vorsichtig aufgeschmolzen. Unterhalb des Siliziumstabes sammelt sich eine Schmelze aus aufgeschmolzenem Silizium, in die, in der Regel von unten, ein Impfkristall aus monokristallinem Silizium eingetaucht wird. Sobald der Impfkristall mit der Siliziumschmelze benetzt ist, kann mit der Kristallzüchtung begonnen werden, indem die Siliziumschmelze langsam aus der Heizzone abgesenkt wird. Der aufzuschmelzende Siliziumstab muss gleichzeitig von oben nachgeführt werden, so dass das Volumen der Schmelze im Wesentlichen konstant bleibt. Beim Absenken der Schmelze bildet sich an ihrer Unterseite eine Erstarrungsfront aus, entlang derer das flüssige Silizium in der gewünschten Struktur kristallisiert.

Die Herstellung von monokristallinem Silizium ausgehend von metallurgischem Silizium gestaltet sich energetisch sehr aufwendig. Sie ist gekennzeichnet durch eine komplexe Abfolge von chemischen Prozessen und Aggregatzustandsänderungen. Verwiesen wird in diesem Zusammenhang beispielsweise auf die bereits erwähnte WO 2009/121558 A2. Das in dem dort beschriebenen mehrstufigen Prozess gewonnene Silizium fällt in einem Pyrolysereaktor in Form von festen Stangen an, die zur anschließenden Weiterverarbeitung, beispielsweise in einem Czochralski-Verfahren oder einem FZ-Verfahren, gegebenenfalls zerkleinert und wieder aufgeschmolzen werden müssen.

Der vorliegenden Erfindung lag die Aufgabe zugrunde, eine neue Technik zur Herstellung von monokristallinem Silizium bereitzustellen, die sich insbesondere durch einen vereinfachten Verfahrensablauf sowie durch energetische Optimierung gegenüber aus dem Stand der Technik bekannten Verfahrensabläufen auszeichnet.

Diese Aufgabe wird gelöst durch das Verfahren mit den Merkmalen des Anspruchs 1 sowie die Anlage mit den Merkmalen des Anspruchs 4. Bevorzugte Ausführungsformen des erfindungsgemäßen Verfahrens finden sich in den abhängigen Ansprüchen 2 und 3. Eine bevorzugte Ausführungsform der erfindungsgemäßen Anlage ist im abhängigen Anspruch 5 angegeben.

Mit einem erfindungsgemäßen Verfahren können grundsätzlich die unterschiedlichsten Halbleiteniverkstoffe in monokristalliner Form erhalten werden. Insbesondere eignet sich ein erfindungsgemäßes Verfahren zur Herstellung von monokristallinem Silizium. Es umfasst dabei stets zumindest die folgenden Schritte:
1. In einem Schritt wird ein Halbleiterwerkstoff als Ausgangsmaterial bereitgestellt. Bei dem Halbleiterwerkstoff handelt es sich bevorzugt um Silizium.
2. In einem weiteren Schritt wird das Ausgangsmaterial in eine Heizzone überführt. In dieser Heizzone befindet sich eine Schmelze aus dem Halbleiterwerkstoff, die mit Ausgangsmaterial gespeist wird. Bei der Schmelze handelt es sich wie bei klassischen FZ-Verfahren, z.B. dem in der EP 1595006 B1 beschriebenen Verfahren, um eine "frei schwebende Schmelze". Darunter ist eine Schmelze zu verstehen, die nicht in Kontakt mit den Wänden eines Gefäßes wie eines Tiegels steht. Stattdessen wird ihre Stabilität kontaktlos aufrechterhalten, worauf unten noch näher eingegangen wird.
3. Durch Absenken der Schmelze aus der Heizzone oder alternativ durch Anheben der Heizzone kann die Ausbildung einer Erstarrungsfront am unteren Ende der Schmelze herbeigeführt werden, entlang derer der Halbleiterwerkstoff in der gewünschten monokristallinen Struktur erstarrt. Grundsätzlich kann das Absenken der Schmelze aus der Heizzone und das erwähnte Anheben der Heizzone auch gleichzeitig erfolgen.

Besonders zeichnet sich das erfindungsgemäße Verfahren dadurch aus, dass das Ausgangsmaterial aus dem Halbleiterwerkstoff in flüssiger Form bereitgestellt und auch flüssig in die Schmelze eingespeist wird.

Das erfindungsgemäße Verfahren weist somit einige Gemeinsamkeiten mit klassischen FZ-Verfahren auf, insbesondere die erwähnte "frei schwebende Schmelze". Das Aufrechterhalten und Stabilisieren der Schmelze sowie die Abkühlung der Schmelze, insbesondere durch Absenkung der Schmelze aus dem Heizbereich, kann grundsätzlich gemäß aus dem Stand der Technik bekannten Vorgehensweisen erfolgen, wie sie z.B. in der EP 1595006 B1 beschrieben und erwähnt sind. Im Unterschied zu klassischen FZ-Verfahren wird die Schmelze allerdings nicht durch Nachführen eines festen Halbleitermaterials, insbesondere eines festen Siliziumstabes, wie er eingangs erwähnt ist, gespeist. Stattdessen wird die Schmelze mit Ausgangsmaterial gespeist, das nicht erst unmittelbar oberhalb der Schmelze aufgeschmolzen sondern in bereits verflüssigter Form herangeführt wird.

Zur Bildung der gewünschten monokristallinen Struktur wird die Schmelze bevorzugt mit einem Keim aus einem monokristallinen Halbleiterwerkstoff, insbesondere einem Keim aus monokristallinem Silizium, geimpft, der, insbesondere von unten, in die Schmelze eingetaucht werden kann. Die Schmelze erstarrt entsprechend beim Erkalten entlang der Erstarrungsfront an ihrem unteren Ende in einer monokristallinen Struktur.

In der deutschen Patentanmeldung mit dem Aktenzeichen DE 10 2010 011 853 A1 sowie der als WO 2010/060630 A2 veröffentlichten internationalen Anmeldung werden jeweils Verfahren zur Siliziumgewinnung beschrieben, bei denen Silizium in flüssiger Form erhalten wird. Die vorliegend beschriebene Erfindung baut auf diesen Verfahren auf.

Zur Bereitstellung des flüssigen Ausgangsmaterials werden Partikel aus dem Halbleiterwerkstoff und/oder eine Vorläuferverbindung des Halbleiterwerkstoffs in einen Gasstrom eingespeist. In den Gasstrom können sowohl Partikel aus dem Halbleiterwerkstoff als auch eine Vorläuferverbindung des Halbleiterwerkstoffs eingespeist werden. Der Gasstrom weist eine ausreichend hohe Temperatur auf, um die Partikel aus dem Halbleiterwerkstoff aus dem festen in den flüssigen und/oder gasförmigen Zustand zu überführen und/oder um die Vorläuferverbindung thermisch zu zersetzen.

Die Vorläuferverbindung des Halbleiterwerkstoffs könnte grundsätzlich zwar auch direkt erwärmt werden, so dass es zu einer thermischen Zersetzung der Vorläuferverbindung kommt, beispielsweise indem ihr mittels elektrostatischer oder elektromagnetischer Felder Energie zugeführt wird, um sie in einen plasmaartigen Zustand zu überführen. Bevorzugt wird sie zur Zersetzung aber in einen hocherhitzten Gasstrom eingespeist.

Bei den Partikeln aus dem Halbleiterwerkstoff handelt es sich insbesondere um metallische Siliziumpartikel, wie sie zum Beispiel beim Zersägen von Siliziumblöcken zu dünnen Waferscheiben aus Silizium in großen Mengen anfallen können. Unter Umständen können die Partikel oberflächlich zumindest leicht oxidiert sein.

Bei der Vorläuferverbindung des Halbleiterwerkstoffs handelt es sich bevorzugt um eine Silizium-Wasserstoff-Verbindung, besonders bevorzugt um Monosilan (SiH₄). Allerdings ist beispielsweise auch die Verwendung von anderen siliziumhaltigen Verbindungen, insbesondere von Chlorsilanen wie zum Beispiel insbesondere Trichlorsilan (SiHCl₃), möglich.

Der Gasstrom, in den die Partikel aus dem Halbleiterwerkstoff und/oder die Vorläuferverbindung des Halbleiterwerkstoffes eingespeist werden, umfasst in der Regel mindestens ein Trägergas. In bevorzugten Ausführungsformen besteht er aus einem solchen. Der Anteil an der Vorläuferverbindung des Halbleiterwerkstoffes in der Mischung mit dem mindestens einen Trägergas liegt besonders bevorzugt zwischen 5 Gew.-% und 99 Gew.-%, insbesondere zwischen 5 Gew.-% und 50 Gew.-%, besonders bevorzugt zwischen 5 Gew.-% und 20 Gew.-%. Als Trägergas kommt insbesondere Wasserstoff in Frage, was insbesondere dann vorteilhaft ist, wenn es sich bei der Vorläuferverbindung um eine Silizium-Wasserstoff-Verbindung handelt. In weiteren bevorzugten Ausführungsformen kann es sich bei dem Trägergas auch um eine Trägergasmischung, beispielsweise aus Wasserstoff und einem Edelgas, insbesondere Argon, handeln. Das Edelgas ist dann in der Trägergasmischung bevorzugt in einem Anteil zwischen 1% und 50% enthalten.

Der Gasstrom weist bevorzugt eine Temperatur zwischen 500 °C und 5000 °C, besonders bevorzugt zwischen 1000 °C und 5000 °C, insbesondere zwischen 2000 °C und 4000 °C, auf. Bei einer solchen Temperatur können zum einen z.B. Partikel aus Silizium verflüssigt bzw. im Gasstrom sogar mindestens teilweise verdampft werden. Auch Silizium-Wasserstoff-Verbindungen und andere denkbare Vorläuferverbindungen des Halbleiterwerkstoffs werden bei solchen Temperaturen in der Regel ohne weiteres in ihre elementaren Bestandteile zersetzt.

Besonders bevorzugt handelt es sich bei dem Gasstrom um ein Plasma, insbesondere um ein Wasserstoff-Plasma. Bei einem Plasma handelt es sich bekanntlich um ein teilweise ionisiertes Gas, das zu einem nennenswerten Anteil freie Ladungsträger wie Ionen oder Elektronen enthält. Erhalten wird ein Plasma stets durch äußere Energiezufuhr, welche insbesondere durch thermische Anregung, Bestrahlungsanregung oder durch Anregung durch elektrostatische oder elektromagnetische Felder erfolgen kann. Vorliegend ist insbesondere die letztere Anregungsmethode bevorzugt. Entsprechende Plasmageneratoren sind kommerziell erhältlich und müssen im Rahmen der vorliegenden Anmeldung nicht näher erläutert werden.

Nach dem Einspeisen der Partikel aus dem Halbleiterwerkstoff und/oder der Vorläuferverbindung des Halbleiterwerkstoffes in den Gasstrom ist es erforderlich, entstehenden gasförmigen Halbleiterwerkstoff aus dem Gasstrom auszukondensieren (sofern erforderlich) sowie den entstehenden gasförmigen und/oder flüssigen Halbleiterwerkstoff gegebenenfalls von der Trägergaskomponente abzutrennen. Hierfür kommt erfindungsgemäß ein Reaktorbehälter zum Einsatz, in den der Gasstrom mit den Partikeln aus dem Halbleiterwerkstoff und/oder der Vorläuferverbindung des Halbleiterwerkstoffs bzw. mit entsprechenden gasförmigen und/oder flüssigen Folgeprodukten aus diesen eingeleitet wird. Ein solcher Reaktorbehälter dient zum Sammeln und gegebenenfalls zum Kondensieren des flüssigen und/oder gasförmigen Halbleiterwerkstoffs. Insbesondere ist er dazu vorgesehen, die in bevorzugten Ausführungsformen des erfindungsgemäßen Verfahrens entstehende Mischung aus Trägergas, Halbleiterwerkstoff (flüssig und/oder gasförmig) und gegebenenfalls gasförmigen Zerfallsprodukten aufzutrennen.

Im Rahmen eines erfindungsgemäßen Verfahrens wird das so gewonnene flüssige Ausgangsmaterial unmittelbar aus dem Reaktorbehälter in die Schmelze aus dem Halbleiterwerkstoff eingespeist.

Wie bereits eingangs erwähnt, liegt ein großer Vorteil der FZ-Technik darin, dass zum Beispiel flüssiges Silizium beim Auskristallisieren nicht mit den Wänden eines Tiegels in Kontakt kommt, wie dies zum Beispiel beim Czochralski-Verfahren der Fall ist. Selbst wenn die Tiegelwände aus sehr hochtemperaturstabilen Material wie z.B. Quarz gefertigt werden, können aus den Reaktorwänden Fremdelemente wie Sauerstoff in das flüssige Silizium diffundieren und dessen Eigenschaften beeinflussen, zumindest wenn der Kontakt zum flüssigen Silizium über einen längeren Zeitraum besteht. Grundsätzlich wäre ein Eindiffundieren von Fremdatomen in flüssige Halbleitermaterialien wie flüssiges Silizium natürlich auch ausgehend von Wänden des erwähnten Reaktorbehälters bzw. des erwähnten Sammelbehälters möglich. Es wäre entsprechend wünschenswert, wenn das flüssige Halbleitermaterial auch mit diesen Wänden nicht oder zumindest nicht über längere Zeit unmittelbar in Kontakt treten würde.

In bevorzugten Ausführungsformen sind der Reaktorbehälter und/oder der Sammelbehälter deshalb innenseitig mit einer festen Schicht (wird auch als "skull" bezeichnet) aus dem erstarrten Halbleiterwerkstoff überzogen. Dies gilt insbesondere für die Bereiche der Innenwände, die mit dem flüssigem Halbleitermaterial unmittelbar in Kontakt treten können, also beispielsweise für die Bodenbereiche der Behälter, in denen sich gegebenenfalls z.B. auskondensiertes flüssiges Silizium sammelt. Die feste Schicht aus dem erstarrten Halbleiterwerkstoff schirmt die Behälterwände von flüssigem Halbleitermaterial ab (bzw. umgekehrt), ein permanentes Eindiffundieren von Verunreinigungen in das flüssige Halbleitermaterial wird dadurch verhindert.

Die Dicke der Schicht aus dem erstarrten Halbleiterwerkstoff wird bevorzugt mittels eines Sensors überwacht. Dies kann sehr wichtig sein, da die Schicht idealerweise eine gewisse Mindestdicke aufweisen, gleichzeitig aber nicht unkontrolliert wachsen sollte. Es ist entsprechend erforderlich, innerhalb der Behälter ein thermisches Gleichgewicht aufrechtzuerhalten, insbesondere im Bereich der Behälterwände. Hierzu können, insbesondere innerhalb der Wände, Heiz- und/oder Kühlmittel vorgesehen sein, die idealerweise über eine Steuerung mit dem erwähnten Sensor gekoppelt sind, um eventuellen Schwankungen der Dicke durch entsprechende Maßnahmen entgegenwirken zu können. Als Sensor eignen sich insbesondere Ultraschallsensoren. Auch die Durchführung von Leitfähigkeitsmessungen ist denkbar.

Erfindungsgemäß weist der Reaktorbehälter einen Bodenbereich auf, der zumindest teilweise aus dem herzustellenden Halbleiterwerkstoff, insbesondere aus hochreinem Silizium, besteht. Insbesondere ist es auch möglich, dass der Reaktorbehälter im Bodenbereich einen Auslass für flüssiges Halbleitermaterial aufweist, der durch einen Pfropf aus dem erstarrten Halbleitermaterial blockiert ist. Zum Einspeisen des flüssigen Halbleitermaterials in die Schmelze wird der zumindest teilweise aus dem herzustellenden Halbleiterwerkstoff bestehende Bodenbereich, insbesondere der "Pfropf" aus dem erstarrten Halbleitermaterial, der den erwähnten Auslass blockiert, kontrolliert aufgeschmolzen. Auf diese Weise ist es möglich, die Menge an flüssigem Halbleiterwerkstoff, die in die Schmelze eingespeist wird, zu kontrollieren.

Um die Schmelze selbst stabil zu halten, ist es erforderlich, der Schmelze nicht zu viel flüssigen Halbleiterwerkstoff zuzuführen. Deshalb ist eine Kontrolle der Menge des in die Schmelze eingespeisten Halbleiterwerkstoffs sehr wichtig. Der hydrostatische Druck in der Schmelze ist nämlich direkt proportional zu ihrer Höhe. Diese sollte also stets in einem gewissen, recht eng gesteckten Bereich gehalten werden. Das Volumen der Schmelze sollte deshalb im Wesentlichen konstant bleibt. Es sollte nicht mehr flüssiger Halbleiterwerkstoff zugeführt werden, als gleichzeitig am unteren Ende der Schmelze erstarrt.

Alternativ oder zusätzlich kann die in die Schmelze eingespeiste Menge an flüssigem Halbleiterwerkstoff natürlich auch gesteuert werden, indem die Menge der Partikel aus dem Halbleiterwerkstoff und/oder der Vorläuferverbindung des Halbleiterwerkstoffs, die in den erwähnten hocherhitzten Gasstrom eingespeist werden, entsprechend dosiert wird. Die Menge z.B. an der Vorläuferverbindung, die in den Gasstrom eingespeist wird, kann sehr fein dosiert werden. Es ist so möglich, kontinuierlich genau definierbare Mengen an flüssigem Halbleiterwerkstoff zu erzeugen. Für die Beibehaltung der Schmelzzonenstabilität kann diese Vorgehensweise von großem Vorteil sein und auch eine aufwendige Kontrolle des Ablaufs des flüssigen Halbleiterwerkstoffs aus dem Reaktorbehälter ist so nicht zwingend erforderlich.

Das Aufschmelzen des mindestens teilweise aus hochreinem Halbleiterwerkstoff bestehenden Bodenbereichs wird mittels Heiz- und/oder Kühlmitteln, die im Bodenbereich des Reaktorbehälters angeordnet oder diesem zumindest zugeordnet sind, kontrolliert. Dabei umfassen die Heiz- und/oder Kühlmittel mindestens eine Induktionsheizung, mit der der Bodenbereich des Reaktorbehälters erwärmt werden kann. Die Kühlmittel sind in bevorzugten Ausführungsformen in den Bodenbereich des Reaktorbehälters integriert, insbesondere um den erwähnten Auslass für flüssiges Halbleitermaterial herum angeordnet.

Alternativ oder zusätzlich zu der mindestens einen Induktionsheizung können die Heiz- und/oder Kühlmittel auch mindestens einen fokussierbaren Licht- und/oder Materiestrahl umfassen. Bei einem solchen fokussierbaren Licht- und/oder Materiestrahl kann es sich insbesondere um einen Laser oder um einen Elektronenstrahl handeln. Mittels diesem können - lokal begrenzt - z.B. aus dem herzustellenden Halbleiterwerkstoff bestehende Teilbereiche des Bodenbereichs des Reaktorbehälters und/oder des Sammelbehälters oder der blockierende Pfropf aus erstarrtem Halbleitermaterial gezielt verflüssigt werden, so dass ein Auslass geöffnet wird, über den flüssiger Halbleiterwerkstoff austreten kann. Durch Variation der Intensität und Fokussierung des Licht- und/oder Materiestrahl lässt sich die Größe des verflüssigten Bereichs beeinflussen. Ein unkontrollierter Austritt von flüssigem Silizium kann so vermieden werden.

Auch die Heizzone, in der die Schmelze aus dem Halbleiterwerkstoff angeordnet ist, umfasst bevorzugt mindestens ein Heizmittel, bei dem es sich insbesondere um eine Induktionsheizung und/oder einen fokussierbaren Licht- und/oder Materiestrahl handeln kann. In bevorzugten Ausführungsformen kann ein und dasselbe Heizmittel, insbesondere ein und dieselbe Induktionsheizung, sowohl zum Aufrechterhalten der Schmelze in der Heizzone als auch zum Erwärmen des Bodenbereichs des Reaktorbehälters dienen.

Das erfindungsgemäße Verfahren lässt sich grundsätzlich in allen Anlagen durchführen, die eine Quelle für einen als Ausgangsmaterial dienenden flüssigen Halbleiterwerkstoff, ein Heizmittel zum Herstellen und/oder Aufrechterhalten einer in einem Heizbereich angeordneten frei schwebenden Schmelze aus dem Halbleiterwerkstoff, Mittel zum Absenken der Schmelze aus dem Heizbereich und/oder Mittel zum Anheben des Heizbereichs sowie bevorzugt auch Mittel zum kontrollierten Einspeisen des als Ausgangsmaterial dienenden flüssigen Halbleiterwerkstoffs in die Schmelze umfasst. Auch eine solche Anlage ist Gegenstand der vorliegenden Erfindung.

Bei der Quelle für den als Ausgangsmaterial dienenden flüssigen Halbleiterwerkstoff handelt es sich um den oben erwähnten Reaktorbehälter. Dieser umfasst in der Regel einen hitzebeständigen Innenraum. Damit dieser durch den oben beschriebenen hocherhitzten Gasstrom nicht zerstört wird, ist er in der Regel mit entsprechenden hochtemperaturstabilen Materialien ausgekleidet. Geeignet sind beispielsweise Auskleidungen auf Basis von Graphit oder Siliziumnitrid. Dem Fachmann sind geeignete hochtemperaturbeständige Materialien bekannt.

Innerhalb des Reaktorbehälters spielt insbesondere die Frage des Übergangs von gegebenenfalls gebildeten Dämpfen wie Siliziumdämpfen in die flüssige Phase eine große Rolle. Dafür ist natürlich die Temperatur der Reaktorinnenwände ein wichtiger Faktor. Sie liegt bevorzugt im Bereich des Schmelzpunkts von Silizium, auf jeden Fall aber unterhalb des Siedepunkts von Silizium. Bevorzugt wird die Temperatur der Wände auf einem relativ niedrigen Niveau gehalten, insbesondere knapp unterhalb des Schmelzpunkts von Silizium. Dies gilt insbesondere dann, wenn sich auf der Innenseite des Reaktorbehälters, wie oben beschrieben, eine Schicht aus erstarrtem Halbleitermaterial, insbesondere aus erstarrtem Silizium, ausbilden soll. Zur Einstellung der dafür erforderlichen Temperaturen kann der Reaktorbehälter geeignete Isolier-, Heiz- und/oder Kühlmittel aufweisen.

Flüssiger Halbleiterwerkstoff sollte sich am Reaktorboden sammeln können. Der Boden des Reaktorinnenraumes kann dazu konisch ausgebildet sein mit einem Ablauf am tiefsten Punkt, um das Abführen des flüssigen Halbleiterwerkstoffs zu erleichtern. Der Reaktorbehälter weist zum kontrollierten Abführen des flüssigen Halbleiterwerkstoffs den bereits beschriebenen zumindest teilweise aus dem herzustellenden Halbleiterwerkstoff bestehenden Bodenbereich auf, insbesondere den Auslass für flüssiges Halbleitermaterial, der durch einen Pfropf aus dem erstarrten Halbleitermaterial blockiert ist. Diesem Auslass bzw. dem Bodenbereich kann ein zusätzliches Blockiermittel zugeordnet sein, mit dem ein unkontrolliertes Abfließen von flüssigem Halbleitermaterial aus dem Reaktor unterbunden werden kann. Dieses Blockiermittel besteht bevorzugt aus einem Material, das sich durch Hochfrequenzinduktion nicht oder zumindest weniger gut erwärmen lässt als Silizium. Bevorzugt sind insbesondere Materialien, die einen höheren Schmelzpunkt als Silizium aufweisen. Das Blockiermittel kann beispielsweise als Platte oder als Schieber ausgebildet sein, mit der sich z.B. der Auslass für das flüssige Halbleitermaterial verschließen lässt.

Weiterhin muss natürlich auch das in den Reaktorbehälter eingeleitete bzw. das dort durch Zersetzung gegebenenfalls gebildete Gas wieder abgeführt werden. Neben einer Zuleitung für den Gasstrom ist dafür in der Regel eine entsprechende Gasableitung vorgesehen.

Der Gasstrom wird bevorzugt bei relativ hohen Geschwindigkeiten in den Reaktorbehälter eingeleitet, um eine gute Verwirbelung innerhalb des Reaktorbehälters zu gewährleisten. Im Reaktorbehälter herrscht bevorzugt ein Druck leicht oberhalb Normaldruck, insbesondere zwischen 1013 und 2000 Millibar (mbar).

Mindestens ein Abschnitt des Reaktorinnenraumes ist in bevorzugten Ausführungsformen im Wesentlichen zylindrisch ausgebildet. Die Einleitung des Gasstroms kann über einen in den Innenraum mündenden Kanal erfolgen. Die Mündung dieses Kanals ist besonders im oberen Bereich des Innenraumes angeordnet, bevorzugt am oberen Ende des im Wesentlichen zylindrischen Abschnitts.

Bei den Mitteln zum kontrollierten Einspeisen des als Ausgangsmaterial dienenden flüssigen Halbleiterwerkstoffs in die Schmelze handelt es sich bevorzugt um Rinnen und/oder Rohre. Mit diesen kann der flüssige Halbleiterwerkstoff aus dem Reaktorbehälter in den Heizbereich überführt werden. Gefertigt werden können die Rinnen und/oder Rohre beispielsweise aus Quartz, aus Graphit oder aus Siliziumnitrid. Gegebenenfalls können diesen Mitteln Heizeinrichtungen zugeordnet sein, um einem Erstarren des flüssigen Halbleiterwerkstoffs beim Transport vorzubeugen. In bevorzugten Ausführungsformen können die Mittel in den Bereichen, die mit dem flüssigen Halbleiterwerkstoff in Kontakt treten, auch mit einer festen Schicht aus dem erstarrten Halbleiterwerkstoff überzogen sein, wie dies auch bei dem oben beschriebenen Reaktorbehälter der Fall ist. Auch hierfür kann die erfindungsgemäße Anlage geeignete Heiz- und/oder Kühlmittel umfassen.

Weiterhin können die Mittel zum kontrollierten Einspeisen des als Ausgangsmaterial dienenden flüssigen Halbleiterwerkstoffs in die Schmelze auch die oben bereits beschriebenen Heiz- und/oder Kühlmittel umfassen, mit denen das Aufschmelzen des mindestens teilweise aus hochreinem Halbleiterwerkstoff bestehenden Bodenbereichs kontrolliert wird. Insbesondere können sie in Kombination eine Induktionsheizung umfassen, die zum Aufrechterhalten der frei schwebenden Schmelze dient sowie zum Erwärmen des Bodenbereichs des Reaktorbehälters und gleichzeitig mindestens einen fokussierbaren Licht- und/oder Materiestrahl, mit dessen Hilfe - lokal begrenzt - aus dem Halbleiteniverkstoff bestehende Teilbereiche des Bodenbereichs des Reaktorbehälters und/oder des Sammelbehälters gezielt verflüssigt werden können.

Wie oben bereits erwähnt, kann in dem Reaktorbehälter flüssiger Halbleiterwerkstoff nach Bedarf erzeugt werden, indem die Menge an Partikeln aus dem Halbleiterwerkstoff und/oder an der Vorläuferverbindung des Halbleiterwerkstoffs, die in den hocherhitzten Gasstrom eingespeist wird, entsprechend variiert wird. Insbesondere in diesem Fall kann die Kopplung der Oberführungsmittel an den Reaktorbehälter, in dem der flüssige Halbleiterwerkstoff aus dem Gasstrom auskondensiert und/oder abgetrennt wird, beispielsweise über eine siphonartige Rohrverbindung erfolgen. Der entstehende flüssige Halbleiterwerkstoff sammelt sich im Reaktorbehälter und erzeugt einen entsprechenden hydrostatischen Druck. Über die siphonartige Rohrverbindung kann, bedingt durch diesen Druck, flüssiger Halbleiterwerkstoff kontrolliert aus dem Reaktorbehälter abgeführt bzw. der Schmelze, in der dann der Übergang des flüssigen Halbleiterwerkstoffs in den festen Zustand unter Ausbildung von monokristallinen Kristallstrukturen erfolgt, zugeführt werden.

Das erfindungsgemäße Verfahren bietet gegenüber klassischen Techniken zur Gewinnung von monokristallinen Halbleiterwerkstoffen klare Vorteile. Aus energetischer Sicht ist es sehr vorteilhaft, flüssig anfallende Halbleiterwerkstoffe unmittelbar in eine monokristalline Form zu überführen, ohne den Umweg über polykristallines Halbleitermaterial. Weiterhin passiert das Halbleitermaterial, bedingt durch den stark verkürzten Verfahrensablauf, nur noch sehr wenige potentielle Verunreinigungsquellen. Es lässt sich somit Halbleitermaterial in sehr hoher Reinheit herstellen.

Weitere Merkmale der Erfindung ergeben sich aus der nachfolgenden Beschreibung einer bevorzugten Ausführungsform einer erfindungsgemäßen Anlage zur Herstellung eines monokristallinen Halbleiterwerkstoffes. Die beschriebene bevorzugte Ausführungsform dient lediglich zur Erläuterung um zum besseren Verständnis der Erfindung und ist in keiner Weise einschränkend zu verstehen.

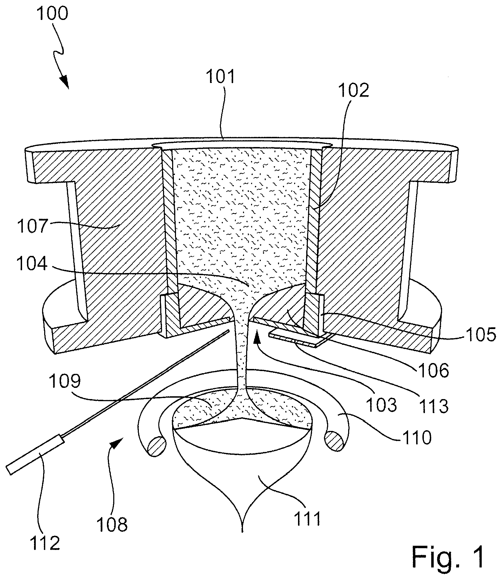

**Fig. 1** zeigt die schematische Darstellung einer bevorzugten Ausführungsform einer erfindungsgemäßen Anlage **100,** die zur Herstellung eines monokristallinen Halbleiterwerkstoffes dient.

Als Quelle für einen als Ausgangsmaterial dienenden flüssigen Halbleiterwerkstoff weist die Anlage den Reaktorbehälter **101** auf. Der im Schnitt dargestellte Reaktorbehälter umfasst einen zylindrischen Abschnitt, der seitlich durch die Reaktorinnenwand **102** begrenzt ist. Der Teil des Reaktors oberhalb des zylindrischen Abschnitts ist nicht dargestellt, er umfasst u.a. einen Einlass für ein siliziumhaltiges Plasma sowie einen Auslass für aus dem Reaktor abzuführende Gase. Das Plasma wird in einer dem Reaktorbehälter **101** vorgeschalteten Vorrichtung aus einem Trägergas erzeugt und mit Partikeln aus dem Halbleiterwerkstoff und/oder einer Vorläuferverbindung des Halbleiterwerkstoffs versetzt. Unterhalb des zylindrischen Abschnitts verjüngt sich der Reaktorinnenraum bis hin zum Auslass **103,** über den flüssiger Halbleiterwerkstoff **104** aus dem Reaktorbehälter **101** austreten kann. Die Ausgestaltung dieses Teils des Reaktorinnenraumes ist insbesondere durch die L-förmigen gekühlten Wand-/Bodenelemente **105** bedingt, die sich an die Unterseite der Reaktorinnenwand **102** anschließen. Diese werden auf einer Temperatur unterhalb der Schmelztemperatur des im Reaktorbehälter **101** enthaltenen Halbleiterwerkstoffs gehalten. Dieser bildet entsprechend eine erstarrte Deckschicht **106** aus, die sich gegebenenfalls auch über den Auslass **103** erstrecken und den Auslass somit blockieren kann. Der Reaktorbehälter **101** weist somit einen Bodenbereich auf, der zumindest teilweise aus dem herzustellenden Halbleiterwerkstoff besteht. Um die Reaktorinnenwand **102** und L-förmigen gekühlten Wand-/Bodenelemente **105** herum ist die Reaktoraußenwand **107** angeordnet. Diese kann Heiz-, Isolier- und und/oder Kühlmittel umfassen.

Unterhalb des Reaktorbehälters **101** ist die Heizzone **108** angeordnet, in der sich eine Schmelze **109** aus dem Halbleiterwerkstoff befindet. Die Heizzone **108** umfasst als Heizmittel die Induktionsheizung **110,** die ringförmig um die Schmelze **109** herum angeordnet ist. Für letztere dient der Impfling **111** als Unterlage. Dieser kann über geeignete Mittel samt der Schmelze **109** aus der Heizzone **108** abgesenkt werden, so dass sich am unteren Ende der Schmelze **109** eine Erstarrungsfront ausbildet, entlang derer der Halbleiterwerkstoff in der monokristallinen Struktur des Endkonus **111** kristallisiert.

Die Induktionsheizung **110** dient insbesondere zum Aufrechterhalten der Schmelze **109** in der Heizzone **108.** Weiterhin erwärmt sie aber auch den Bodenbereich des Reaktorbehälters **101.** Durch Zuschalten des Lasers **112,** der als Mittel zum kontrollierten Einspeisen des als Ausgangsmaterial dienenden flüssigen Halbleiterwerkstoffs in die Schmelze **109** derart angordnet ist, dass er auf den Auslass **103** fokussiert werden kann, lässt sich den Auslass **103** gegebenenfalls blockierender Halbleiterwerkstoff aufschmelzen, so dass die Schmelze **109** kontrolliert mit flüssigem Halbleiterwerkstoff gespeist werden kann.

Um ein unkontrolliertes Auslaufen des Reaktorbehälters **101** zu verhindern, umfasst die erfindungsgemäße Anlage **100** als Sicherung das Blockiermittel **113,** bei dem es sich um einen Schieber handelt, mit dem der Auslass **103** verschlossen werden kann. Der Schieber besteht bevorzugt aus einem Material, welches sich durch Hochfrequenzinduktion nicht oder kaum erwärmen lässt.

## Patentansprüche

1. Verfahren zur Herstellung eines monokristallinen Halbleiterwerkstoffs, insbesondere von monokristallinem Silizium, umfassend die Schritte
- Bereitstellen eines Ausgangsmaterials aus dem Halbleiterwerkstoff,
- Überführen des Ausgangsmaterials in eine Heizzone, in der eine Schmelze aus dem Halbleiteniverkstoff mit dem Ausgangsmaterial gespeist wird,
- Absenken der Schmelze aus der Heizzone und/oder Anheben der Heizzone, so dass sich am unteren Ende der Schmelze eine Erstarrungsfront ausbildet, entlang derer der Halbleiterwerkstoff in der gewünschten Struktur kristallisiert,
wobei das Ausgangsmaterial aus dem Halbleiterwerkstoff in flüssiger Form bereitgestellt und flüssig in die Schmelze eingespeist wird, indem
- Partikel aus dem Halbleiterwerkstoff und/oder eine Vorläuferverbindung des Halbleiterwerkstoffs in einen Gasstrom eingespeist werden, wobei der Gasstrom eine ausreichend hohe Temperatur aufweist, um die Partikel aus dem Halbleiterwerkstoff aus dem festen in den flüssigen und/oder gasförmigen Zustand zu überführen und/oder um die Vorläuferverbindung thermisch zu zersetzen,
- der Gasstrom in einen Reaktorbehälter geleitet wird, der einen festen Bodenbereich aufweist, der zumindest teilweise aus dem herzustellenden Halbleiterwerkstoff besteht, in dem das flüssige Ausgangsmaterial aus dem Gasstrom kondensiert und/oder abgetrennt wird, und
- das flüssige Ausgangsmaterial unmittelbar aus dem Reaktorbehälter in die Schmelze aus dem Halbleiterwerkstoff eingespeist wird, indem der zumindest teilweise aus dem herzustellenden Halbleiterwerkstoff bestehende Bodenbereich kontrolliert aufgeschmolzen wird, wobei der Aufschmelzvorgang mit Heiz- und/oder Kühlmitteln, die im Bodenbereich angeordnet oder diesem zugeordnet sind, kontrolliert wird, und die Heiz- und/oder Kühlmittel mindestens eine Induktionsheizung und/oder einen fokussierbaren Licht- und/oder Materiestrahl umfassen.

2. Verfahren nach Anspruch 1, **dadurch gekennzeichnet, dass** der Reaktorbehälter innenseitig, insbesondere in den Bereichen, die mit dem flüssigen Halbleitermaterial in Kontakt treten, mit einer festen Schicht aus dem erstarrten Halbleiterwerkstoff überzogen ist.

3. Verfahren nach Anspruch 2, **dadurch gekennzeichnet, dass** die Dicke der Schicht mittels eines Sensors, insbesondere mittels eines Ultraschallsensors, überwacht und durch Heiz- und/oder Kühlmittel gesteuert wird.

4. Anlage zur Herstellung eines monokristallinen Halbleiterwerkstoffs, insbesondere von monokristallinem Silizium, umfassend als Quelle für einen als Ausgangsmaterial dienenden flüssigen Halbleiterwerkstoff einen Reaktorbehälter der einen festen Bodenbereich aufweist, der zumindest teilweise aus dem herzustellenden Halbleiterwerkstoff besteht, Heiz- oder Kühlmittel zum kontrollierten Aufschmelzen des aus dem herzustellenden Halbleiterwerkstoff bestehenden Bodenbereichs, wobei die Heiz- und/oder Kühlmittel im Bodenbereich angeordnet oder diesem zugeordnet sind und mindestens eine Induktionsheizung und/oder einen fokussierbaren Licht- und/oder Materiestrahl umfassen, sowie Heizmittel zum Herstellen und/oder Aufrechterhalten einer Schmelze aus dem Halbleiterwerkstoff sowie bevorzugt auch Mittel zum kontrollierten Einspeisen des als Ausgangsmaterial dienenden flüssigen Halbleiterwerkstoffs in die Schmelze.

5. Anlage nach Anspruch 4, **dadurch gekennzeichnet, dass** die Mittel zum kontrollierten Einspeisen des als Ausgangsmaterial dienenden flüssigen Halbleiterwerkstoffs in die Schmelze Rinnen und/oder Rohre umfassen, die vorzugsweise zumindest teilweise aus Quarz, Graphit und/oder Siliziumnitrid bestehen.

## Claims

1. Method for producing a monocrystalline semiconductor material, in particular monocrystalline silicon, comprising the steps of:
- providing a starting material composed of the semiconductor material,
- transferring the starting material into a heating zone, in which a melt composed of the semiconductor material is fed with the starting material,
- lowering the melt from the heating zone and/or raising the heating zone, such that, at the lower end of the melt, a solidification front forms along which the semiconductor material crystallizes in the desired structure,
wherein the starting material composed of the semiconductor material is provided in liquid form and fed into the melt in liquid form, in that
- particles of the semiconductor material and/or a precursor compound of the semiconductor material are fed into a gas flow, wherein the gas flow has sufficiently high temperature to convert the particles of the semiconductor material from the solid to the liquid and/or gaseous state and/or to thermally decompose the precursor compound,
- the gas flow is conducted into a reactor container which has a solid bottom region which at least partly consists of the semiconductor material to be produced, in which reactor container the liquid starting material is condensed and/or separated from the gas flow, and
- the liquid starting material is fed directly from the reactor container into the melt composed of the semiconductor material, in that the bottom region which at least partly consists of the semiconductor material to be produced is melted in a controlled manner, wherein the melting process is controlled by means of heating and/or cooling media which are arranged in the bottom region or are assigned thereto, and the heating and/or cooling media comprise at least one induction heating system and/or a focusable light beam and/or beam of matter.

2. Method according to Claim 1, **characterized in that** the reactor container is coated internally, in particular in the regions which come into contact with the liquid semiconductor material, with a solid layer composed of the solidified semiconductor material.

3. Method according to Claim 2, **characterized in that** the thickness of the layer is monitored by means of a sensor, in particular by means of an ultrasonic sensor, and controlled by heating and/or cooling media.

4. Installation for producing a monocrystalline semiconductor material, in particular monocrystalline silicon, comprising, as source of a liquid semiconductor material serving as starting material, a reactor container which has a solid bottom region which at least partly consists of the semiconductor material to be produced, heating or cooling media for the controlled melting of the bottom region which consists of the semiconductor material to be produced, wherein the heating and/or cooling media are arranged in the bottom region or are assigned thereto and comprise at least one induction heating system and/or a focusable light beam and/or beam of matter, and also heating media for producing and/or maintaining a melt composed of the semiconductor material, and preferably also media for the controlled feeding of the liquid semiconductor material serving as starting material into the melt.

5. Installation according to Claim 4, **characterized in that** the means for the controlled feeding of the liquid semiconductor material serving as starting material into the melt comprise grooves and/or pipes, which preferably at least partly consist of quartz, graphite and/or silicon nitride.

## Revendications

1. Procédé de production d'un matériau semiconducteur monocristallin, notamment de silicium monocristallin, comprenant les étapes suivantes
- fourniture d'une matière première constituée du matériau semiconducteur,
- transfert de la matière première dans une zone de chauffage dans laquelle est injectée une masse fondue constituée du matériau semiconducteur avec la matière première,
- abaissement de la masse fondue hors de la zone de chauffage et/ou levage de la zone de chauffage, de sorte qu'il se produise à l'extrémité inférieure de la masse fondue une solidification le long de laquelle le matériau semiconducteur se cristallise dans la structure souhaitée,
la matière première constituée du matériau semiconducteur étant fournie sous forme liquide et étant injectée liquide dans la masse fondue, en ce que
- des particules du matériau semiconducteur et/ou d'un composé précurseur du matériau semiconducteur sont injectées dans un flux de gaz, le flux de gaz présentant une température suffisamment élevée pour transférer les particules du matériau semiconducteur depuis l'état solide à l'état liquide et/ou gazeux et/ou pour décomposer thermiquement le composé précurseur,
- le flux de gaz est acheminé dans une cuve de réacteur qui possède une zone de fond fixe, laquelle se compose au moins partiellement du matériau semiconducteur à produire, dans laquelle la matière première liquide est condensée et/ou séparée du flux gazeux, et
- la matière première liquide est injectée directement hors de la cuve de réacteur dans la masse fondue constituée du matériau semiconducteur, en ce que la zone de fond composée au moins partiellement du matériau semiconducteur à produire est mise en fusion de manière contrôlée, l'opération de mise en fusion étant contrôlée par des moyens de chauffage et/ou de refroidissement qui sont disposés dans la zone de fond ou qui sont associés à celle-ci, et les moyens de chauffage et/ou de refroidissement comprennent au moins un dispositif de chauffage par induction et/ou un rayon de lumière et/ou un jet de matière qui peut être concentré.

2. Procédé selon la revendication 1, **caractérisé en ce que** le côté intérieur de la cuve de réacteur est revêtu d'une couche fixe du matériau semiconducteur solidifié, notamment dans les zones qui entrent en contact avec le matériau semiconducteur liquide.

3. Procédé selon la revendication 2, **caractérisé en ce que** l'épaisseur de la couche est surveillée au moyen d'un capteur, notamment au moyen d'un capteur à ultrasons, et commandée par les moyens de chauffage et/ou de refroidissement.

4. Équipement de production d'un matériau semiconducteur monocristallin, notamment de silicium monocristallin, comprenant comme source d'un matériau semiconducteur liquide servant de matière première une cuve de réacteur qui possède une zone de fond fixe, laquelle se compose au moins partiellement du matériau semiconducteur à produire, des moyens de chauffage ou de refroidissement destinés à la mise en fusion contrôlée de la zone de fond constituée du matériau semiconducteur à produire, les moyens de chauffage et/ou de refroidissement étant disposés dans la zone de fond ou associés à celle-ci et comprenant au moins un dispositif de chauffage par induction et/ou un rayon de lumière et/ou un jet de matière qui peut être concentré, ainsi que des moyens de chauffage destinés à créer et/ou à maintenir une masse fondue constituée du matériau semiconducteur ainsi que de préférence aussi des moyens destinés à l'injection contrôlée du matériau semiconducteur liquide servant de matière première dans la masse fondue.

5. Équipement selon la revendication 4, **caractérisé en ce que** les moyens destinés à l'injection contrôlée du matériau semiconducteur liquide servant de matière première dans la masse fondue comprennent des goulottes et/ou des tubes qui se composent de préférence au moins partiellement de quartz, de graphite et/ou de nitrure de silicium.
